(19) Europäisches Patentamt
European Patent Office
Office européen des brevets

(11) **EP 4 429 446 B1**

(12) **EUROPEAN PATENT SPECIFICATION**

(45) Date of publication and mention
of the grant of the patent:
**03.09.2025 Bulletin 2025/36**

(21) Application number: **24162232.3**

(22) Date of filing: **08.03.2024**

(51) International Patent Classification (IPC):
**H10N 30/079** (2023.01)    **H10N 30/853** (2023.01)
**H10N 30/00** (2023.01)

(52) Cooperative Patent Classification (CPC):
**H10N 30/708; H10N 30/079; H10N 30/8542;**
H10N 30/078

(54) **METHOD FOR MANUFACTURING PIEZOELECTRIC SUBSTRATE AND PIEZOELECTRIC SUBSTRATE**

VERFAHREN ZUR HERSTELLUNG EINES PIEZOELEKTRISCHEN SUBSTRATS UND PIEZOELEKTRISCHES SUBSTRAT

PROCÉDÉ DE FABRICATION D'UN SUBSTRAT PIÉZOÉLECTRIQUE ET SUBSTRAT PIÉZOÉLECTRIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **10.03.2023 JP 2023037305**

(43) Date of publication of application:
**11.09.2024 Bulletin 2024/37**

(73) Proprietor: **Seiko Epson Corporation
Tokyo 160-8801 (JP)**

(72) Inventors:
• **NAGANO, Daisuke
Suwa-shi, 392-8502 (JP)**
• **HORIBA, Yasuhiro
Suwa-shi, 392-8502 (JP)**

(74) Representative: **Lewis Silkin LLP
Arbor
255 Blackfriars Road
London SE1 9AX (GB)**

(56) References cited:
**US-A1- 2014 132 676    US-A1- 2016 284 969
US-B2- 8 084 925    US-B2- 8 304 966**

**Description**

The present patent is based on, and claims priority from JP Application Serial Number 2023-037305, filed March 10, 2023.

BACKGROUND

1. Technical Field

The present disclosure relates to a method for manufacturing a piezoelectric substrate and a piezoelectric substrate.

2. Related Art

Generally, a piezoelectric substrate includes a substrate, a piezoelectric layer having electromechanical conversion characteristics, and two electrode layers that sandwich the piezoelectric layer. In recent years, devices using such a piezoelectric substrate as a driving source (piezoelectric element application devices) have been actively developed. As one of the piezoelectric element application devices, a liquid ejecting head represented by an ink jet type recording head, a MEMS element represented by a piezoelectric MEMS element, an ultrasonic measurement device represented by an ultrasonic sensor or the like, and a piezoelectric actuator device or the like are provided.

As a material (piezoelectric material) of the piezoelectric layer of the piezoelectric substrate, lead zirconate titanate (PZT) is known. However, in recent years, from a viewpoint of reducing an environmental load, progress has been made in development of a lead-free piezoelectric material with a reduced content of lead.

JP-A-2011-29591 discloses a piezoelectric thin film element in which a lithium potassium sodium niobate thin film is formed using a sputtering method at a silicon substrate, and an internal stress of the lithium potassium sodium niobate thin film is 1.6 GPa or less.

JP-A-2011-29591 is an example of the related art.

Further examples of KNN films with controlled internal stress can be found in US 2016/284969 A1, US 2014/132676 A1, US 8 084 925 B2 and US 8 304 966 B2.

SUMMARY

The piezoelectric substrate is manufactured by laminating the substrate, the electrode layers, and the piezoelectric layer made of different materials. Therefore, when a temperature change occurs because of a heat treatment or the like, since thermal expansion coefficients of the materials are different, there is a problem that the entire piezoelectric substrate is warped due to a thermal stress. Further, when a warpage amount increases, a problem such as a crack occurring in the piezoelectric substrate, particularly in the piezoelectric layer, or interlayer delamination occurring between the substrate and the piezoelectric layer may occur.

In order to solve such a problem, JP-A-2011-29591 discloses that an internal stress in the piezoelectric layer is reduced by controlling film formation conditions, and the warpage amount of the piezoelectric substrate due to the thermal stress is reduced. However, when a diameter of the silicon substrate (wafer) is increased, the warpage amount of the substrate increases even when the diameter is the same. As a result, when a positional deviation of a patterning mask occurs, or a case where a manufacturing device cannot sufficiently hold the wafer occurs, productivity may deteriorate.

Under these circumstances, there is a need for a piezoelectric substrate that can reduce the warpage amount of the entire substrate due to the thermal stress.

Such a problem is not limited to existing in a piezoelectric substrate used in a piezoelectric actuator mounted on a liquid ejecting head represented by an ink jet type recording head, and also exists in a piezoelectric substrate used in other piezoelectric element application devices.

In order to solve the problems described above, a first aspect of the present disclosure provides a method for manufacturing a piezoelectric substrate, the method including: a first film formation step of forming a first electrode at a substrate; a second film formation step of forming a seed layer at the first electrode; a processing step of removing or modifying at least a part of the seed layer; and a third film formation step of forming a piezoelectric layer containing potassium, sodium, and niobium at the seed layer and the first electrode, in which the substrate includes a stress relaxation region, and in the processing step, the seed layer corresponding to the stress relaxation region is removed or modified.

BRIEF DESCRIPTION OF THE DRAWINGS

FIG. 1 is a cross-sectional view schematically showing a piezoelectric substrate according to a first embodiment.

FIG. 2 is a flowchart illustrating a method for manufacturing the piezoelectric substrate according to the first embodiment.

FIG. 3 is a cross-sectional view schematically showing a process of manufacturing the piezoelectric substrate according to the first embodiment.

FIG. 4 is a cross-sectional view schematically showing a process of manufacturing the piezoelectric substrate according to the first embodiment.

FIG. 5 is a cross-sectional view schematically showing a process of manufacturing the piezoelectric substrate according to the first embodiment.

DESCRIPTION OF EMBODIMENTS

Hereinafter, embodiments of the present disclosure will be described with reference to the drawings. The following description shows an aspect of the present disclosure, and can be optionally changed within a range not departing from the gist of the present disclosure. In the drawings, the same reference signs denote the same members, and description thereof will be appropriately omitted. The numeral after the characters forming the reference signs are referred to with reference signs including the same characters, and used for distinguishing elements having similar structures from each other. When it is not necessary to distinguish elements indicated by reference signs including the same characters from each other, the elements will be referred to with reference signs including only characters.

In the drawings, X, Y, and Z represent three spatial axes orthogonal to one another. In the present specification, directions along the axes are a first direction X (X direction), a second direction Y (Y direction), and a third direction Z (Z direction), respectively. A direction facing an arrow in each drawing is described as a positive (+) direction, and a direction opposite to the arrow is described as a negative (-) direction. The X direction and the Y direction represent an in-plane direction of a plate, a layer, and a film, and the Z direction represents a thickness direction or a lamination direction of the plate, the layer, and the film.

Elements shown in the drawings, that is, a shape or a size of each part, thicknesses of a plate, a layer, and a film, a relative positional relationship, a repeated unit, and the like may be exaggeratedly shown for the purpose of describing the present disclosure. Further, the term "at" in the present specification does not limit a positional relationship of elements to "directly above". For example, expressions such as "a first electrode at a substrate" and "a piezoelectric layer at the first electrode" to be described later do not exclude a fact that another element is provided between the substrate and the first electrode or between the first electrode and the piezoelectric layer.

First Embodiment

First, a piezoelectric substrate and a method for manufacturing the piezoelectric substrate according to the first embodiment will be described with reference to the drawings.

Piezoelectric Substrate

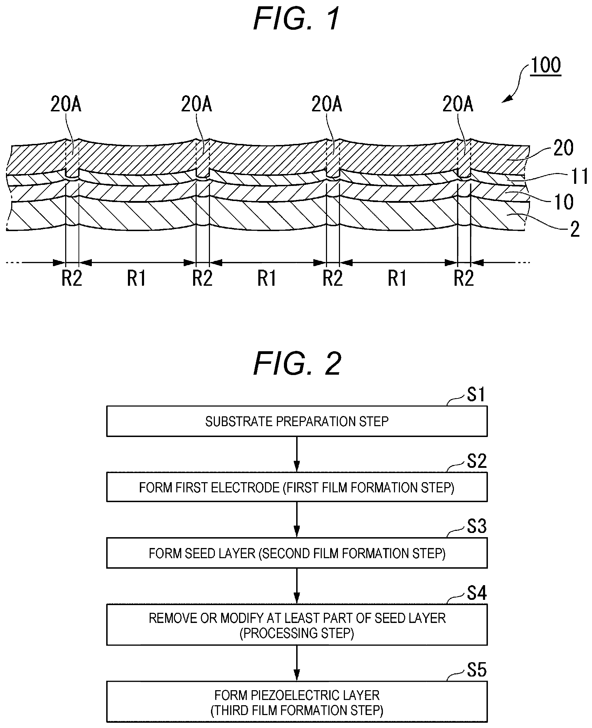

FIG. 1 is a cross-sectional view schematically showing a piezoelectric substrate 100 according to the embodiment.

As shown in FIG. 1, the piezoelectric substrate 100 includes a substrate 2, a first electrode (lower electrode) 10, a seed layer 11, and a piezoelectric layer 20.

The substrate 2 is a flat plate formed of, for example, a semiconductor or an insulator. The substrate 2 may be a single layer, or a laminate where a plurality of layers are laminated. An internal structure of the substrate 2 is not limited as long as an upper surface has a planar shape, and the substrate 2 may have a structure in which a space or the like is formed therein.

The substrate 2 may include a vibration plate that has flexibility and that deforms by an operation of the piezoelectric layer 20. The vibration plate is, for example, a silicon oxide layer, a titanium oxide layer, a zirconium oxide layer, a laminate where the zirconium oxide layer is provided at the silicon oxide layer, or a laminate where the titanium oxide layer and the zirconium oxide layer are provided at the silicon oxide layer.

The substrate 2 includes active portion regions (first regions) R1 that are regions functioning as devices, and stress relaxation regions (second regions) R2 that are regions other than the active portion regions R1. The stress relaxation region R2 is a region for reducing orientation and crystallinity of the piezoelectric layer 20, and is a region that does not function as a device. That is, the stress relaxation region R2 is provided at a portion that substantially coincides with a line cut when the piezoelectric substrate 100 is divided into a desired device chip size. The stress relaxation region R2 corresponds to a region where a part of the seed layer 11 is removed or modified, which will be described later.

The first electrode 10 is provided at the substrate 2. The first electrode 10 is provided between the substrate 2 and the piezoelectric layer 20. A shape of the first electrode 10 is, for example, a layer. A thickness of the first electrode 10 is, for example, 20 nm or more and 200 nm or less. The first electrode 10 is, for example, a metal layer such as a platinum layer, an iridium layer, or a ruthenium layer, a conductive oxide layer thereof, a lanthanum nickelate ($LaNiO_3$: LNO) layer, or a strontium ruthenate ($SrRuO_3$: SRO) layer. The first electrode 10 may have a structure in which a plurality of layers exemplified above are laminated.

An adhesion layer (not shown) such as a titanium layer may be provided between the substrate 2 and the first electrode 10. The adhesion layer is formed of, for example, a titanium oxide ($TiO_X$), titanium (Ti), or SiN, and has a function of improving adhesiveness between the piezoelectric layer 20 and the substrate 2. Further, when the titanium oxide ($TiO_X$) layer, the titanium (Ti) layer, or a silicon nitride (SiN) layer is used as the adhesion layer, the adhesion layer also has a function serving as a stopper to prevent constituent elements of the piezoelectric layer 20 (for example, potassium and sodium) from passing through the first electrode 10 and reaching the substrate 2 when forming the piezoelectric layer 20 to be described later. The adhesion layer may be omitted.

The first electrode 10 is one electrode for applying a voltage to the piezoelectric layer 20. The first electrode 10 is a lower electrode provided below the piezoelectric layer 20. The first electrode 10 may be an individual electrode or a common electrode.

The seed layer (orientation control layer) 11 is provided at the first electrode 10, and has a function of controlling orientation of crystals of a piezoelectric body constituting the piezoelectric layer 20. That is, by providing the seed layer 11 at the first electrode 10, the crystals of the piezoelectric body constituting the piezoelectric layer 20 can be preferentially oriented in a predetermined plane orientation (for example, (100) plane). When the crystal orientation of the piezoelectric layer 20 is improved, it is possible to efficiently use domain rotation and improve displacement characteristics of the piezoelectric layer 20.

At least a part of the seed layer 11 is removed or modified. Specifically, at least a part of the seed layer 11 at a position corresponding to the stress relaxation region R2 is removed or modified by laser irradiation or the like. Therefore, a thermal mark may be formed as a trace of the seed layer 11 at a position corresponding to the stress relaxation region R2. When removing the seed layer 11 at the position corresponding to the stress relaxation region R2, the entire seed layer 11 may be removed in a thickness direction or the seed layer 11 may be removed such that a part thereof remains. Further, by adjusting removal conditions (for example, laser irradiation conditions), the seed layer 11 can be modified without being removed. Crystal grains of the piezoelectric layer 20 formed at any location where the seed layer 11 is removed or modified are not preferentially oriented in a predetermined plane orientation by the seed layer. Therefore, a crack can occur in the stress relaxation region R2, and warpage of the entire piezoelectric substrate 100 can be reduced.

A surface roughness of the piezoelectric layer 20 in the stress relaxation region R2 may be larger than a surface roughness of the piezoelectric layer 20 in the active portion region R1. As described above, since the crystal grains of the piezoelectric layer 20 formed at the portion where the seed layer 11 is removed or modified are not preferentially oriented in a predetermined plane orientation by the seed layer, the surface roughness of the piezoelectric layer 20 in the stress relaxation region R2 is large.

A thickness of the seed layer 11 is, for example, 1 nm or more and 20 nm or less. The thickness of the seed layer 11 referred here is a thickness of a portion not removed or modified for forming the stress relaxation region R2.

Examples of a material of the seed layer 11 include a compound containing bismuth, iron, titanium, and lead, lithium and niobium oxides (LiNbO), zinc oxide (ZnO), $KNbO_3$, $NaNbO_3$, $LaNiO_3$, $SrRuO_3$, $SrTiO_3$, TiO, Zn, and Ti. Among them, the compound containing bismuth, iron, titanium, and lead is preferred. When the compound containing bismuth, iron, titanium, and lead is used as the material of the seed layer 11, the crystal structure of the KNN-based piezoelectric layer 20 can be further stabilized. That is, when the piezoelectric layer 20 is formed using the compound containing bismuth, iron, titanium, and lead as the seed layer 11, stability of potassium and sodium in the piezoelectric layer 20 can be improved. As a result, diffusion of potassium and sodium toward a substrate 2 side can be further prevented.

The piezoelectric layer 20 is provided at the first electrode 10, and is formed in the active portion region R1 and the stress relaxation region R2 above the substrate 2. A thickness of the piezoelectric layer 20 is, for example, 100 nm or more and 3000 nm or less. The piezoelectric layer 20 can deform by applying a voltage between the first electrode 10 and a second electrode (not shown) that is an upper electrode.

The piezoelectric layer 20 is preferably a composite oxide having a perovskite structure represented by a general formula $ABO_3$, and more preferably contains a piezoelectric material represented by the following formula (1) and formed of potassium sodium niobate (KNN-based composite oxide; $(K, Na)NbO_3$).

$$(K_X, Na_{1-X})NbO_3... \qquad (1)$$

$$(0.1 \leq X \leq 0.9)$$

The composite oxide represented by above formula (1) is a so-called KNN-based composite oxide. The KNN-based composite oxide is a lead-free piezoelectric material with a reduced content of lead (Pb) or the like, and therefore has excellent biocompatibility and a small environmental load. Further, the KNN-based composite oxide is excellent in piezoelectric characteristics among a lead-free piezoelectric material, and is therefore advantageous in improving various characteristics.

The piezoelectric layer 20 may contain an additive other than elements (for example, niobium, potassium, sodium, and oxygen) constituting the composite oxide having a perovskite structure described above. That is, the piezoelectric layer 20 may be, for example, a KNN layer to which an additive is added. Examples of such an additive include manganese (Mn).

The piezoelectric layer 20 does not contain, for example, lead (Pb). The piezoelectric layer 20 being free of lead can be confirmed by, for example, X-Ray fluorescence (XRF) measurement.

The upper electrode (second electrode) is provided at the piezoelectric layer 20. The second electrode may be further provided at a side surface of the piezoelectric layer 20 and at the substrate 2 as long as the second electrode is electrically separated from the first electrode 10.

A shape of the second electrode is, for example, a layer. The second electrode is, for example, a metal layer such as an iridium layer, a platinum layer, or a ruthenium layer, a conductive oxide layer thereof, a lanthanum nickelate layer, or a strontium ruthenate layer. The second electrode may have a structure in which a plurality of layers exemplified above are laminated. The material of the first electrode 10 and the material of the second electrode may be the same as or different from each other.

The second electrode is another electrode for applying a voltage to the piezoelectric layer 20. The second electrode functions as the upper electrode provided at the piezoelectric layer 20.

As shown in FIG. 1, in the piezoelectric substrate 100 according to the embodiment, a plurality of first regions R1 and a plurality of second regions R2 have a downwardly convex shape. That is, it can be said that when the piezoelectric substrate 100 is viewed in a cross section, both the first regions R1 and the second regions R2 are curved toward the substrate 2 side, and the substrate 2 has a plurality of centers of curvature.

States of warpage of the first region R1 and the second region R2 may be different from each other. For example, a curvature radius of the first region R1 is smaller than a curvature radius of the second region R2. In this way, when the first region R1 and the second region R2 have curvatures instead of providing one curvature over the entire piezoelectric substrate 100, a residual stress of the piezoelectric layer 20 can be relaxed, and a warpage amount of the entire piezoelectric substrate 100 can be reduced.

As described above, the second region R2 that is the stress relaxation region corresponds to the region where a part of the seed layer 11 is removed or modified. That is, the second region R2 is a region for intentionally reducing the crystal orientation. In the piezoelectric layer 20 corresponding to the second region R2, the orientation and the crystallinity naturally deteriorate. Crystal grains not on a preferentially oriented plane by the seed layer increase in size. When the orientation and the crystallinity of the piezoelectric layer 20 deteriorate, a crack is more likely to occur preferentially in the piezoelectric layer 20 than in the first region R1 that is the active portion region. As a result, even when a thermal stress is applied to the entire piezoelectric substrate 100, the stress can be relaxed in the second region R2 and the warpage amount of the entire piezoelectric substrate 100 can be reduced.

Method for Manufacturing Piezoelectric Substrate

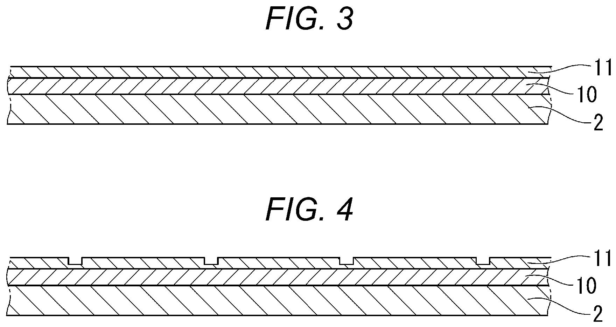

Next, a method for manufacturing the piezoelectric substrate 100 will be described with reference to the drawings. FIG. 2 is a flowchart illustrating the method for manufacturing the piezoelectric substrate 100. FIGS. 3 to 5 are cross-sectional views schematically showing processes of manufacturing the piezoelectric substrate 100. In the following description, a case where the piezoelectric layer 20 is manufactured by a chemical solution method (wet method) will be described. However, the method for manufacturing the piezoelectric layer 20 is not limited to the wet method, and may be, for example, a gas phase method. When the piezoelectric layer 20 is formed by the gas phase method, a direction of the warpage of the piezoelectric substrate 100 may be upwardly convex. That is, in the solution method and the gas phase method, directions of the warpage of the piezoelectric substrate 100 may be different. However, other configurations are the same, and operations and effects thereof are also similar.

As shown in FIG. 3, the substrate 2 is prepared (substrate preparation step; step S1).

Specifically, for example, a silicon oxide layer is formed by thermally oxidizing a silicon substrate. Next, a zirconium layer is formed by a sputtering method or the like at the silicon oxide layer, and a zirconium oxide layer is formed by thermally oxidizing the zirconium layer. The substrate 2 can be prepared by the above steps.

Next, the first electrode 10 is formed at the substrate 2 (first film formation step; step S2).

The first electrode 10 is formed by, for example, a sputtering method or a vacuum deposition method. When an adhesion layer is provided, the first electrode 10 is formed after a metal titanium film or the like is formed as the adhesion layer at the substrate 2. The adhesion layer can be formed by a sputtering method or the like.

Next, the seed layer 11 is formed at the first electrode 10 (second film formation step; step S3).

The seed layer 11 is formed by, for example, a sputtering method, a vacuum deposition method, or a chemical solution method (wet method). As described above, examples of the material of the seed layer 11 include the compound containing bismuth, iron, titanium, and lead, lithium and niobium oxides (LiNbO), zinc oxide (ZnO), $KNbO_3$, $NaNbO_3$, $LaNiO_3$, $SrRuO_3$, $SrTiO_3$, TiO, Zn, and Ti. Among them, the compound containing bismuth, iron, titanium, and lead is preferred.

Next, as shown in FIG. 4, at least a part of the seed layer 11 is removed or modified (processing step; step S4).

The seed layer 11 corresponding to the stress relaxation region R2 in the seed layer 11 is removed or modified. Accordingly, the orientation and the crystallinity of the piezoelectric layer 20 formed at the seed layer 11 are reduced. That is, since the region where the seed layer 11 is removed or modified is a region that does not function as a device, the region where the seed layer 11 is removed is the portion that substantially coincides with the line cut when the piezoelectric substrate 100 is divided into a desired device chip size, and the seed layer 11 in a region that functions as the device remains. FIG. 4 shows a case where a part of the seed layer 11 corresponding to the stress relaxation region R2 is removed such that a part of the seed layer 11 remains, but the embodiment is not limited thereto. The entire seed layer 11 corresponding to the stress relaxation region R2 may be removed, or the seed layer 11 may be modified by controlling a laser output to an extent that ablation does not occur.

The seed layer 11 may be removed or modified by emitting a laser onto the seed layer 11. Specifically, ablation processing using laser light may be adopted. Laser irradiation conditions are not particularly limited. When performing the ablation processing using the laser light, a type of the laser light may be any type as long as the laser light can impart excessive thermal energy to a film, and may be pulse light or continuous light in a wavelength range from IR to UV. When performing the processing step by the laser irradiation, the stress relaxation region R2 can be formed in any shape without forming a resist mask or the like.

The seed layer 11 may be removed by etching. Since the etching has a larger number of steps than the laser processing, the etching may be poor in productivity. However, since the etching is more excellent in mass productivity than the laser processing, the etching may be appropriately selected.

The seed layer 11 may be removed by blasting. Similar to the etching, since the blasting has a large number of steps, the blasting may be poor in productivity. However, since the blasting is more excellent in mass productivity than the laser processing, and is more excellent in surface modification properties than the etching, the blasting may be appropriately selected.

A processing width (a width of an irradiation trace in a case of the laser irradiation) when removing or modifying the seed layer 11 is not particularly limited. However, when it is considered that the stress relaxation region R2 is a region that does not function as a device, it is not preferable that the processing width is excessively large. Further, when the processing width is excessively small, the region may not sufficiently function as the region for reducing the orientation and the crystallinity of the piezoelectric layer 20. Therefore, the processing width when removing or modifying the seed layer 11 is preferably 1 $\mu$m to 100 $\mu$m.

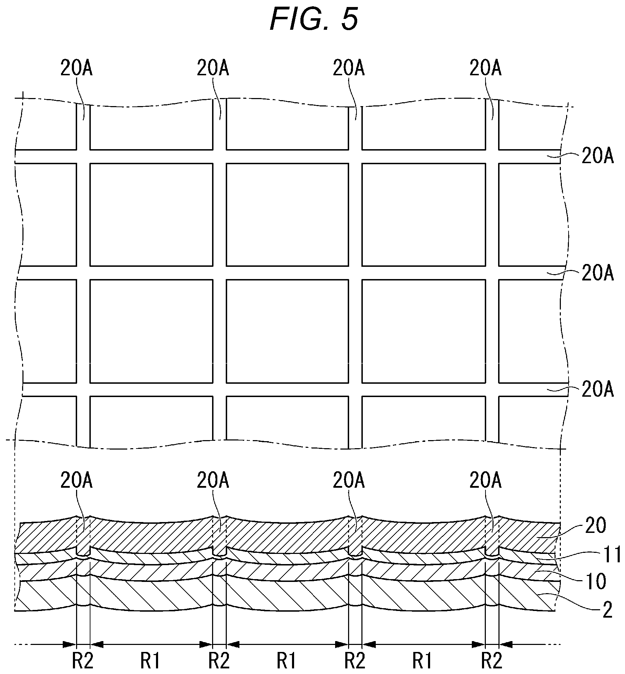

Next, as shown in FIG. 5, the piezoelectric layer 20 is formed (third film formation step; step S5). The piezoelectric layer 20 is obtained by, for example, forming a plurality of piezoelectric films. The piezoelectric layer 20 is formed of the plurality of piezoelectric films. The piezoelectric layer 20 can be formed by, for example, a chemical solution method (wet method) in which a solution containing a metal complex (precursor solution) is applied and dried, and further fired to obtain a metal oxide. In addition, the piezoelectric layer 20 can also be formed by a laser ablation method, a sputtering method, a pulsed laser deposition method (PLD method), a chemical vapor deposition (CVD) method, an aerosol deposition method, or the like. In the embodiment, from a viewpoint of improving the crystal orientation of the piezoelectric layer 20, it is preferable to use the wet method (liquid phase method).

Here, the wet method is a method for forming a film by a chemical solution method such as a MOD method or a sol-gel method, and is a concept distinguished from a gas phase method such as a sputtering method. In the embodiment, the gas phase method may be used in addition to the wet method.

For example, the piezoelectric layer 20 formed by the wet method (liquid phase method) includes a plurality of piezoelectric films formed by a series of steps including a step of applying a precursor solution to form a precursor film (application step), a step of drying the precursor film (drying step), a step of heating and degreasing the dried precursor film (degreasing step), and a step of firing the degreased precursor film (firing step). That is, the piezoelectric layer 20 is formed by repeating the series of steps from the application step to the firing step a plurality of times. In the series of steps described above, the firing step may be performed after repeating steps from the application step to the degreasing step a plurality of times.

A specific procedure when forming the piezoelectric layer 20 by the wet method (liquid phase method) is, for example, as follows.

First, a precursor solution containing a predetermined metal complex is prepared. The precursor solution is a solution in which a metal complex that can form a composite oxide containing K, Na, and Nb by firing is dissolved or dispersed in an organic solvent. At this time, a metal complex containing an additive such as Mn, Li, or Cu may be further mixed. When the metal complex containing Mn, Li, or Cu is mixed with the precursor solution, insulation properties of the obtained piezoelectric layer 20 can be further enhanced.

Examples of a metal complex containing potassium (K) include potassium 2-ethylhexanoate and potassium acetate. Examples of a metal complex containing sodium (Na) include sodium 2-ethylhexanoate and sodium acetate. Examples of a metal complex containing niobium (Nb) include niobium 2-ethylhexanoate and pentaethoxyniobium. When Mn is added as an additive, examples of a metal complex containing Mn include manganese 2-ethylhexanoate. When Li is added as an additive, examples of a metal complex containing Li include lithium 2-ethylhexanoate. At this time, two or more kinds of metal complexes may be used in combination. For example, as the metal complex containing potassium (K), potassium 2-ethylhexanoate and potassium acetate may be used in combination. Examples of the solvent include 2-n-butoxyethanol, n-octane, or a mixed solvent thereof. The precursor solution may contain an additive for stabilizing dispersion of the metal complex containing K, Na, and Nb. Examples of such an additive include 2-ethylhexanoic acid.

Then, as shown in FIG. 5, the precursor solution described above is applied at the seed layer 11 to form a precursor film (application step).

Next, the precursor film is heated to a predetermined temperature, for example, about 150°C to 300°C, and dried for a certain period of time (drying step).

Next, the dried precursor film is heated to a predetermined temperature, for example, 300°C to 500°C, and degreased by holding the precursor film at the temperature for a certain period of time (degreasing step).

Finally, the degreased precursor film is heated to a high temperature, for example, about 500°C to 900°C, and crystallized by holding the precursor film at the temperature for a certain period of time (firing step). Accordingly, the piezoelectric film is completed.

The heating temperature in the firing step is preferably high from a viewpoint of increasing the density of the piezoelectric layer 20 and improving the crystal directionality. Specifically, the heating temperature is preferably 700°C or higher. More preferably, the heating temperature is 750°C or higher. On the other hand, when the heating temperature in the firing step is excessively high, an alkali metal diffuses into the first electrode 10, and thus the composition of the piezoelectric layer 20 may change and the crystal directionality may deteriorate. Therefore, the heating temperature is preferably 850°C or lower.

Examples of a heating device used in the drying step, the degreasing step, and the firing step include a rapid thermal annealing (RTA) device that performs heating by, for example, irradiation of an infrared lamp, and a hot plate. The piezoelectric layer 20 formed of the plurality of piezoelectric films is formed by repeating the steps described above a plurality of times.

The number of repetitions of the series of steps is not particularly limited. Further, the piezoelectric layer 20 formed of one piezoelectric film may be formed without repeating the steps described above a plurality of times.

In the series of steps from the application step to the firing step, the firing step may be performed after steps from the application step to the degreasing step are repeated a plurality of times.

As shown in FIG. 5, the piezoelectric layer 20 can be formed at the seed layer 11 by the steps described above. In the manufacturing method according to the embodiment, since a part of the seed layer 11 corresponding to the stress relaxation region R2 is removed or modified, the piezoelectric layer 20 formed above the seed layer 11 becomes a low orientation region 20A where the crystallinity and the orientation deteriorate.

The low orientation region 20A where the orientation and the crystallinity deteriorate is a region where there is a large amount of non-uniform and heterogeneous regions per unit area that can become a starting point of a crack, and the crack selectively and intentionally occurs in the region. When such a low orientation region 20A exists at substantially the same position and in substantially the same shape as a dividing line of the device, the stress is divided in the low orientation region 20A even when there is no change in stress in a region other than the low orientation region 20A, that is, the active portion region (first region) R1, and therefore a deformation amount of the entire piezoelectric substrate 100 can be reduced. As a result, the warpage amount can be reduced. Further, since it can be said that in the low orientation region 20A with many cracks, a Young's modulus when looking at the entire region on average is smaller than that in a region where there is no crack, the low orientation region 20A rather than the active portion region R1 (that is, the stress relaxation region R2) largely deforms by an external force during wafer handling. As a result, a crack in the active portion region R1 can be prevented.

The subsequent steps may be appropriately performed when necessary. For example, the second electrode (upper electrode) may be formed at the piezoelectric layer 20, and the piezoelectric layer 20 and the second electrode may be patterned. The second electrode may be formed by, for example, a sputtering method or a vacuum deposition method.

The piezoelectric substrate 100 according to the first embodiment can be manufactured by the steps described above.

In the piezoelectric substrate 100 according to the first embodiment, the second film formation step is executed after the first film formation step. However, as a second embodiment, the first electrode 10 may be patterned between the first film formation step and the second film formation step. That is, in the piezoelectric substrate 100 according to the second embodiment, the first electrode 10 is provided as an individual electrode. When the first electrode 10 is an individual electrode, the second electrode can be set as a common electrode. Accordingly, since the second electrode covers the piezoelectric layer 20, formation of a protection film that covers the piezoelectric layer 20 can be simplified.

The piezoelectric substrate 100 according to the embodiment can be suitably used for a liquid-discharging head and a printer, but is not limited thereto, and can be used in a wide range of applications. The piezoelectric substrate 100 is suitably used as, for example, a piezoelectric actuator such as an ultrasonic motor, a vibrating dust removal device, a piezoelectric transformer, a piezoelectric speaker, a piezoelectric pump, and a pressure-electricity converter. Further, the piezoelectric substrate 100 is suitably used as, for example, a piezoelectric sensor element such as an ultrasonic detector, an angular velocity sensor, an acceleration sensor, a vibration sensor, an inclination sensor, a pressure sensor, a collision sensor, a human sensor, an infrared sensor, a terahertz sensor, a thermal detection sensor, a pyroelectric sensor, and a piezoelectric sensor. Further, the piezoelectric substrate 100 is suitably used as a ferroelectric element such as a ferroelectric memory (FeRAM), a ferroelectric transistor (FeFET), a ferroelectric calculation circuit (FeLogic), and a ferroelectric capacitor. Further, the piezoelectric substrate 100 is suitably used as a voltage-control optical element such as a wavelength converter, an optical waveguide, an optical path modulator, a refractive index control element, and an electronic shutter mechanism.

## Claims

1. A method for manufacturing a piezoelectric substrate (100), the method comprising:

   a first film formation step of forming a first electrode (10) above a substrate (2);
   a second film formation step of forming a seed layer (11) above the first electrode (10);
   a processing step of removing or modifying at least a part of the seed layer (11); and
   a third film formation step of forming a piezoelectric layer (20) containing potassium, sodium, and niobium at the seed layer (11) and the first electrode (10), wherein
   the piezoelectric substrate (100) includes a stress relaxation region (R2), and
   the stress relaxation region (R2) corresponds to a region where at least a part of the seed layer (11) is removed or modified in the processing step.

2. The method for manufacturing a piezoelectric substrate according to claim 1, wherein
   in the processing step, the seed layer (11) is removed or modified by emitting a laser onto the seed layer (11).

3. The method for manufacturing a piezoelectric substrate according to claim 1, wherein
   in the processing step, the seed layer (11) is removed by etching.

4. A piezoelectric substrate comprising:

   a substrate (2) including a first region (R1) and a second region (R2);
   a first electrode layer (10) formed above the substrate (2);
   a seed layer (11) formed in the first region (R1) above the substrate (2); and
   a piezoelectric layer (20) formed in the first region (R1) and the second region (R2) above the substrate (2) and containing potassium, sodium, and niobium, wherein
   the substrate (2) includes a plurality of centers of curvature.

5. The piezoelectric substrate according to claim 4, wherein

   the seed layer (11) contains bismuth, iron, titanium, and lead, and
   a thickness of the seed layer (11) is smaller than a thickness of the piezoelectric layer (20).

6. The piezoelectric substrate according to claim 4, wherein
   a surface roughness of the piezoelectric layer (20) in the second region (R2) is larger than a surface roughness of the piezoelectric layer (20) in the first region (R1).

7. The piezoelectric substrate according to claim 4, wherein
   a thermal mark is formed in the substrate (2) in the second region (R2).

**Patentansprüche**

**1.** Verfahren zur Herstellung eines piezoelektrischen Substrats (100), wobei das Verfahren umfasst:

einen ersten Filmbildungsschritt zum Bilden einer erste Elektrode (10) über einem Substrat (2);
einen zweiten Filmbildungsschritt zum Bilden einer Keimschicht (11) über der ersten Elektrode (10);
einen Bearbeitungsschritt zum Entfernen oder Modifizieren mindestens eines Teils der Keimschicht (11); und
einen dritten Filmbildungsschritt zum Bilden einer piezoelektrischen Schicht (20), die Kalium, Natrium und Niob enthält, an der Keimschicht (11) und der ersten Elektrode (10), wobei
das piezoelektrische Substrat (100) einen Spannungsrelaxationsbereich (R2) enthält und
der Spannungsrelaxationsbereich (R2) einem Bereich entspricht, wo mindestens ein Teil der Keimschicht (11) in dem Bearbeitungsschritt entfernt oder modifiziert wird.

**2.** Verfahren zur Herstellung eines piezoelektrischen Substrats nach Anspruch 1, wobei
die Keimschicht (11) in dem Bearbeitungsschritt durch Emittieren eines Lasers auf die Keimschicht (11) entfernt oder modifiziert wird.

**3.** Verfahren zur Herstellung eines piezoelektrischen Substrats nach Anspruch 1, wobei
die Keimschicht (11) in dem Bearbeitungsschritt durch Ätzen entfernt wird.

**4.** Piezoelektrisches Substrat, umfassend:

ein Substrat (2), das einen ersten Bereich (R1) und einen zweiten Bereich (R2) enthält;
eine erste Elektrodenschicht (10), die über dem Substrat (2) gebildet ist;
eine Keimschicht (11), die in dem ersten Bereich (R1) über dem Substrat (2) gebildet ist; und
eine piezoelektrische Schicht (20), die in dem ersten Bereich (R1) und dem zweiten Bereich (R2) über dem Substrat (2) gebildet ist und Kalium, Natrium und Niob enthält, wobei
das Substrat (2) mehrere Krümmungsmittelpunkte enthält.

**5.** Piezoelektrisches Substrat nach Anspruch 4, wobei

die Keimschicht (11) Wismut, Eisen, Titan und Blei enthält und
eine Dicke der Keimschicht (11) kleiner ist als eine Dicke der piezoelektrischen Schicht (20).

**6.** Piezoelektrisches Substrat nach Anspruch 4, wobei
eine Oberflächenrauheit der piezoelektrischen Schicht (20) in dem zweiten Bereich (R2) größer ist als eine Oberflächenrauheit der piezoelektrischen Schicht (20) in dem ersten Bereich (R1).

**7.** Piezoelektrisches Substrat nach Anspruch 4, wobei
eine thermische Markierung in dem Substrat (2) in dem zweiten Bereich (R2) gebildet ist.

**Revendications**

**1.** Procédé de fabrication d'un substrat piézoélectrique (100), le procédé comprenant :

une première étape de formation de film pour la formation d'une première électrode (10) sur un substrat (2) ;
une deuxième étape de formation de film pour la formation d'une couche d'amorce (11) sur la première électrode (10) ;
une étape de traitement pour l'élimination ou la modification d'au moins une partie de la couche d'amorce (11) ; et
une troisième étape de formation de film pour la formation d'une couche piézoélectrique (20) contenant du potassium, du sodium et du niobium au niveau de la couche d'amorce (11) et de la première électrode (10), dans lequel
le substrat piézoélectrique (100) inclut une région de relâchement des contraintes (R2), et
la région de relâchement des contraintes (R2) correspond à une région où au moins une partie de la couche d'amorce (11) est éliminée ou modifiée dans l'étape de traitement.

**2.** Procédé de fabrication d'un substrat piézoélectrique selon la revendication 1, dans lequel

dans l'étape de traitement, la couche d'amorce (11) est éliminée ou modifiée par émission d'un laser sur la couche d'amorce (11).

3. Procédé de fabrication d'un substrat piézoélectrique selon la revendication 1, dans lequel
dans l'étape de traitement, la couche d'amorce (11) est éliminée par attaque chimique.

4. Substrat piézoélectrique comprenant :

un substrat (2) incluant une première région (R1) et une deuxième région (R2) ;
une première couche d'électrode (10) formée sur le substrat (2) ;
une couche d'amorce (11) formée dans la première région (R1) sur le substrat (2) ; et
une couche piézoélectrique (20) formée dans la première région (R1) et la deuxième région (R2) sur le substrat (2) et contenant du potassium, du sodium et du niobium, dans lequel
le substrat (2) inclut une pluralité de centres de courbure.

5. Substrat piézoélectrique selon la revendication 4, dans lequel

la couche d'amorce (11) contient du bismuth, du fer, du titane et du plomb, et
une épaisseur de la couche d'amorce (11) est inférieure à une épaisseur de la couche piézoélectrique (20).

6. Substrat piézoélectrique selon la revendication 4, dans lequel
une rugosité de surface de la couche piézoélectrique (20) dans la deuxième région (R2) est supérieure à une rugosité de surface de la couche piézoélectrique (20) dans la première région (R1).

7. Substrat piézoélectrique selon la revendication 4, dans lequel
une marque thermique est formée dans le substrat (2) dans la deuxième région (R2).

## FIG. 1

## FIG. 2

| |
|---|
| SUBSTRATE PREPARATION STEP ⟋S1 |
| ↓ |
| FORM FIRST ELECTRODE (FIRST FILM FORMATION STEP) ⟋S2 |
| ↓ |
| FORM SEED LAYER (SECOND FILM FORMATION STEP) ⟋S3 |
| ↓ |
| REMOVE OR MODIFY AT LEAST PART OF SEED LAYER (PROCESSING STEP) ⟋S4 |
| ↓ |
| FORM PIEZOELECTRIC LAYER (THIRD FILM FORMATION STEP) ⟋S5 |

FIG. 3

11
10
2

FIG. 4

11
10
2

## FIG. 5

**EP 4 429 446 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023037305 A
- JP 2011029591 A
- US 2016284969 A1
- US 2014132676 A1
- US 8084925 B2
- US 8304966 B2